# EUROPÄISCHE PATENTSCHRIFT

(11) **EP 1 596 442 B1**
(45) Veröffentlichungstag und Bekanntmachung des Hinweises auf die Patenterteilung: **25.12.2019**
(21) Anmeldenummer: 05005408.9
(22) Anmeldetag: 11.03.2005
(51) Int. Cl.: H01L 33/62, H01L 27/15, H01L 33/30

(54) **Optoelektronischer Halbleiterchip und Verfahren zum Ausbilden einer Kontaktstruktur zur elektrischen Kontaktierung eines optoelektronischen Halbleiterchips**
Optoelectronic semiconductor chip and method of fabricating a contact structure for electrically contacting an optoelectronic semiconductor chip
Puce semiconducteur opto-électronique et procédé de fabrication d'un structure de contact pour relier électriquement un puce semiconducteur opto-électronique

(30) Priorität: 29.04.2004 DE 102004021150; 26.05.2004 DE 102004025684
(43) Veröffentlichungstag der Anmeldung: 16.11.2005
(73) Patentinhaber: OSRAM Opto Semiconductors GmbH, 93055 Regensburg (DE)
(72) Erfinder: Wirth, Ralph, 93186 Pettendorf-Adlersberg (DE)
(74) Vertreter: Epping - Hermann - Fischer

(56) Entgegenhaltungen:
- WO-A2-01/56000
- GB-A- 2 381 381
- JP-A- 8 137 413
- US-A- 5 260 818
- US-A- 5 373 174
- US-A1- 2001 022 495
- US-B1- 6 784 458

## Beschreibung

Die Druckschrift GB 2 381 381 A beschreibt ein lichtemittierendes Bauteil und die Druckschrift US 5,373,174 A beschreibt ein lichtemittierendes Halbleiterbauteil.

Die vorliegende Erfindung betrifft einen optoelektronischen Halbleiterchip mit einer Mehrzahl von Halbleiterfunktionsbereichen, die auf einer Trägerschicht angeordnet sind, und einer Kontaktstruktur zur elektrischen Kontaktierung des optoelektronischen Halbleiterchips. Ferner betrifft die Erfindung ein Verfahren zum Ausbilden einer Kontaktstruktur zur elektrischen Kontaktierung eines optoelektronischen Halbleiterchips mit einer Mehrzahl von auf einer Trägerschicht angeordneten Halbleiterfunktionsbereichen. Bevorzugt ist der Halbleiterchip als LED-Chip ausgebildet.

Bei LED-Chips ist häufig ein möglichst hoher Gesamtlichtfluss des von dem LED-Chip erzeugten Lichts erwünscht.

Der erzeugte Gesamtlichtfluss kann einerseits über die Erhöhung des Betriebsstroms des LED-Chips gesteigert werden. Dadurch wird allerdings die Gefahr eines Ausfalls des LED-Chips aufgrund von strombedingter Degradation - Schädigung des Halbleitermaterials durch Erhöhung des Betriebsstroms - erhöht. Weiterhin steigt mit dem Betriebsstrom gewöhnlich die entstehende Verlustwärme, die über aufwendige Maßnahmen vom LED-Chip abgeleitet werden muss, um die Gefahr eines Ausfalls des LED-Chips gering zu halten.

Andererseits kann zum Erreichen eines höheren Gesamtlichtflusses die aktive Fläche eines LED-Chips vergrößert werden. Hierdurch könnten die Stromdichte und die pro Fläche abzuführende Verlustwärme auch bei hohem Gesamtlichtfluss konstant gehalten werden.

Eine vergrößerte aktive Fläche kann zum Einen durch eine flächige Anordnung einer Mehrzahl von Bauelementen - LED-Chips in einem Gehäuse - erreicht werden. Der Platzbedarf derartiger Module ist jedoch vergleichsweise hoch, die Packungsdichte von LED-Chips und die spezifische Lichtausstrahlung (erzeugter Lichtstrom pro aktiver Fläche) aber vergleichsweise gering.

Zur Vergrößerung der aktiven Fläche kann zum Anderen die laterale Fläche des LED-Chips vergrößert werden.Eine Vergrößerung der Fläche des LED-Chips bringt jedoch eine Erhöhung der Gefahr mit sich, dass der LED-Chip einen herstellungsbedingten Defekt aufweist.

Derartige Defekte können den LED-Chip in seiner Funktion beeinträchtigen oder ihn sogar völlig unbrauchbar machen. Beispielsweise können solche Defekte zu Verringerung der Lichtausbeute durch strahlungslose Rekombination (z.B. Oberflächenrekombination) oder zum Kurzschluß der aktiven Zone des LED-Chips führen. Eine Herstellung von defektfreien Halbleiterschichtenfolgen, die für die Ausbildung von optoelektronischen Halbleiterchips vorgesehen sind, ist aus heutiger Sicht zumindest sehr aufwendig.

Eine Aufgabe der Erfindung ist es, einen optoelektronischen Halbleiterchip anzugeben, dessen aktive Fläche gegenüber herkömmlichen optoelektronischen Halbleiterchips vereinfacht vergrößerbar ist. Weiterhin ist es eine Aufgabe der Erfindung, ein Verfahren zum Ausbilden einer Kontaktstruktur für einen optoelektronischen Halbleiterchip anzugeben, die die Herstellung optoelektronischer Halbleiterchips mit vergrößerter aktiver Fläche erleichtert.

Diese Aufgabe wird erfindungsgemäß durch einen optoelektronischen Halbleiterchip mit den Merkmalen des Patentanspruchs 1 beziehungsweise durch ein Verfahren mit den Merkmalen des Patentanspruchs 8 gelöst.

Ein derartiger optoelektronischer Halbleiterchip kann mit Vorteil im Waferverbund hergestellt werden.

Unter einem Waferverbund ist bei der Erfindung eine auf einer Trägerschicht angeordnete Halbleiterschichtenfolge, die zur Ausbildung zumindest eines Teils der Halbleiterfunktionsbereiche vorgesehen ist, zu verstehen. Die Trägerschicht kann das Aufwachssubstrat, auf dem die Halbleiterschichtenfolge, beispielsweise epitaktisch, gewachsen wurde, oder eine vom Aufwachssubstrat der Halbleiterschichtenfolge verschiedene Schicht umfassen, auf der die Halbleiterschichtenfolge im Verlauf ihrer Prozessierung im Waferverbund angeordnet wird. Auf der letztgenannten, vom Aufwachssubstrat verschiedenen, Trägerschicht kann die Halbleiterschichtenfolge beispielsweise mittels einer Klebe-, einer Lötverbindung oder über ein Waferbonding-Verfahren angeordnet und/oder befestigt werden.

Unter einem Defektbereich ist bei der Erfindung ein Halbleiterfunktionsbereich zu verstehen, der eine bestimmte Maßgabe, beispielsweise einen vorgegebenen Funktionsparameter nicht erfüllt. Insbesondere fällt hierunter ein Defektbereich mit einem letalen Defekt, der, falls mit der Kontaktstruktur leitend verbunden, im Betrieb eine maßgebliche Fehlfunktion, wie den Ausfall des Halbleiterfunktionsbereichs mit dem letalen Defekt, etwa durch Kurzschluss der aktiven Zone, oder gar des gesamten Halbleiterchips verursachen würde.

Insbesondere kann der Defektbereich im Rahmen der Erfindung vor Inbetriebnahme des Halbleiterchips von der Kontaktstruktur elektrisch isoliert, insbesondere getrennt, sein. Der Defektbereich ist dann bei Inbetriebnahme des Halbleiterchips mit Vorteil nicht elektrisch leitend mit der Kontaktstruktur verbunden. Somit wird aufgrund des Defektbereichs, insbesondere im Falle eines letalen Defektes, keine maßgebliche Fehlfunktion des Halbleiterchips verursacht.

Die Halbleiterfunktionsbereiche können zur Strahlungserzeugung oder zum Strahlungsempfang beispielsweise entsprechend der Struktur eines LED-Chips oder eines Photodiodenchips ausgebildet sein. Bevorzugt entsprechen die Abmessungen der einzelnen Halbleiterfunktionsbereiche denen herkömmlicher, bekanntermaßen zuverlässig arbeitender und/oder in hohen Stückzahlen effizient unter hoher Ausbeute herstellbarer Chips.

Funktionsparameter können bei der Erfindung beispielsweise die Emissionswellenlänge (Peak- oder Dominantwellenlänge) einer im Halbleiterfunktionsbereich erzeugten Strahlung, der Lichtstrom beziehungsweise die Strahlungsleistung der erzeugten Strahlung oder die Effizienz des Halbleiterfunktionsbereichs (z.B. interne Quanteneffizienz oder externe Effizienz)sein.

Bei einem zum Strahlungsempfang vorgesehenen Halbleiterfunktionsbereich kann beispielsweise die Wellenlänge maximaler Empfindlichkeit des Halbleiterfunktionsbereichs gegenüber einfallender Strahlung oder die Stärke des Photostroms als Funktionsparameter herangezogen werden.

Auch weitere für optoelektronische Halbleiterchips charakteristische Eigenschaften oder Größen, etwa die Flussspannung, können als Funktionsparameter herangezogen werden.

Ist die Abweichung eines Funktionsparameters des Halbleiterfunktionsbereichs von einem vorgegebenen Sollwert größer als ein zuvor festgelegter Grenzwert, so wird dieser Halbleiterfunktionsbereich als Defektbereich eingestuft.

Die aktive Fläche des Halbleiterchips wird bevorzugt durch die laterale Ausdehnung von aktiven Zonen bestimmt, die in den Halbleiterfunktionsbereichen angeordnet sind und für die Strahlungserzeugung oder für den Strahlungsempfang des optoelektronischen Halbleiterchips ausgebildet sind.

Die lateralen Abmessungen der Halbleiterfunktionsbereiche bzw. der aktiven Zonen sind zweckmäßigerweise so gewählt, dass die Wahrscheinlichkeit, einen Defekt - insbesondere einen letalen Defekt - in einem Halbleiterfunktionsbereich vorzufinden, tolerabel gering ist. Diese Wahrscheinlichkeit kann je nach Materialsystem, auf dem der Halbleiterfunktionsbereich basiert, und/oder der Prozessführung bei der Herstellung der Halbleiterschichtenfolge variieren. Eine Wahrscheinlichkeit von 10%, bevorzugt 5%, besonders bevorzugt 1% oder weniger kann als im obigen Sinne gering angesehen werden

Derartige optoelektronische Halbleiterchips können eine aktive Fläche aufweisen, die 1 mm², bevorzugt 10 mm², besonders bevorzugt 1 cm² oder größer ist. Eine aktive Fläche von einschließlich 10 mm² bis einschließlich 1 cm² hat sich als besonders vorteilhaft erwiesen. Die Wahrscheinlichkeit eines Ausfalls des optoelektronischen Halbleiterchips aufgrund eines letalen Defekts in den Halbleiterfunktionsbereichen ist wegen der Aufteilung der aktiven Fläche auf eine Mehrzahl von Halbleiterfunktionsbereichen und einer gezielten Trennbarkeit der Defektbereiche von der Kontaktstruktur vorteilhaft verringert.

Eine Kontaktstruktur der obigen Art kann die Herstellung eines erfindungsgemäßen optoelektronischen Halbleiterchips mit einer vergleichsweise großen zur Strahlungserzeugung oder zum Strahlungsempfang vorgesehenen aktiven Fläche vorteilhaft erleichtern, indem Defektbereiche, insbesondere solche mit letalen Defekten, von der Kontaktstruktur trennbar oder getrennt sind. Die Gefahr eines Ausfalls oder einer eingeschränkten Funktion des Halbleiterchips aufgrund einer Fehlfunktion in einem Defektbereich wird so vorteilhaft verringert.

Die Halbleiterfunktionsbereiche sind bevorzugt zumindest zum Teil durch Epitaxie auf einem gemeinsamen Aufwachssubstrat hergestellt und/oder gleichartig ausgebildet.

In einer bevorzugten Ausgestaltung der Erfindung enthalten die Halbleiterfunktionsbereiche oder die aktive Zone ein Material aus den Materialsystemen, Inₓ Ga_{y} Al_{1-x-y} P, Inₓ Ga_{y} Al_{1-x-y} N oder Inₓ Ga_{y} Al_{1-x-y} As, jeweils mit 0≤x≤1, 0≤y≤1 und x+y≤1. Hierbei ist Inₓ Ga_{y} Al_{1-x-y} P beispielsweise für Strahlung vom infraroten bis zum gelben Spektralbereich und Inₓ Ga_{y} Al_{1-x-y} N für Strahlung vom grünen bis in den ultravioletten Spektralbereich besonders geeignet. III-V-Halbleitermaterialien, insbesondere die oben genannten, können sich durch vorteilhaft hohe interne Quanteneffizienz auszeichnen.

In einer weiteren bevorzugten Ausgestaltung der Erfindung ist zumindest zwischen einem Teil der Halbleiterfunktionsbereiche und der Trägerschicht eine Spiegelschicht angeordnet. Durch Reflexion von in der aktiven Zone erzeugten oder auf den Halbleiterchip einfallenden Strahlung kann eine derartige Spiegelschicht eine Absorption in der Trägerschicht verringern beziehungsweise die Effizienz des optoelektronischen Halbleiterchips vorteilhaft erhöhen. Die Spiegelschicht kann beispielsweise einen Bragg-Spiegel umfassen und/oder ein Metall enthalten.

Bragg-Spiegel können mit Vorteil, beispielsweise epitaktisch, zusammen mit der Halbleiterschichtenfolge im Waferverbund hergestellt werden.

Eine metallhaltige Spiegelschicht wird vorzugsweise auf die Halbleiterschichtenfolge nach deren Herstellung noch im Waferverbund aufgebracht beziehungsweise auf dieser angeordnet. Die Anordnung kann durch Sputtern oder Aufdampfen erfolgen. Geeignete Metalle können beispielsweise Au, Al, Ag, Pt oder Legierungen mit mindestens einem dieser Materialien sein.

Au beispielsweise zeichnet sich durch eine vorteilhaft hohe Reflektivität im roten Spektralbereich aus, während Al und Ag auch im ultravioletten und blauen Spektralbereich eine hohe Reflektivität aufweisen können.

Gemäß einer vorteilhaften Weiterbildung der Erfindung wird die Spiegelschicht, insbesondere eine metallhaltige Spiegelschicht, auf eine Halbleiterschichtenfolge, die auf einer ersten Trägerschicht angeordnet ist, auf der der ersten Trägerschicht abgewandten Seite der Halbleiterschichtenfolge aufgebracht. Bevorzugt umfasst die erste Trägerschicht das Aufwachssubstrat der Halbleiterschichtenfolge. Nach dem Aufbringen der Spiegelschicht wird der Verbund aus erster Trägerschicht und Halbleiterschichtenfolge seitens der Spiegelschicht auf einer zweiten Trägerschicht angeordnet. Der Verbund kann beispielsweise mittels einer Lotverbindung, einer Klebeverbindung oder eines Waferbonding-Verfahren auf der zweiten Trägerschicht befestigt werden. Die erste Trägerschicht der Halbleiterschichtenfolge kann daraufhin von der Halbleiterschichtenfolge abgelöst werden. Zum Ablösen eignen sich beispielsweise lasergestützte Verfahren, etwa ein Laser-Ablationsverfahren, mechanische Methoden, wie Abschleifen, oder Ätzverfahren.

Unter Ablösen des Aufwachssubstrats der Halbleiterschichtenfolge hergestellte optoelektronische Halbleiterchips werden oftmals auch als Dünnfilm-Chips bezeichnet. Derartig hergestellte, zur Strahlungserzeugung vorgesehene Halbleiterchips können sich, insbesondere mit einer metallhaltigen Spiegelschicht, durch eine im wesentlichen einem Lambertschen-Strahler entsprechende zumindest annähernd kosinusförmige Abstrahlcharakteristik auszeichnen. Ein solcher Dünnfilm-Chip kann in guter Näherung ein Lambertscher Oberflächenstrahler sein und eignet sich von daher besonders gut für die Anwendung in einem Scheinwerfer.

Ein Dünnfilm-Chip kann sich weiterhin insbesondere durch folgende charakteristische Merkmale auszeichnen:
- Die Halbleiterschichtenfolge beziehungsweise die Halbleiterfunktionsbereiche weisen eine Dicke im Bereich von 20µm oder weniger, insbesondere im Bereich von 10 µm auf und/oder
- die Halbleiterschichtenfolge beziehungsweise die Halbleiterfunktionsbereiche enthalten im Falle eines zur Strahlungserzeugung vorgesehenen Dünnfilm-Chips mindestens eine Halbleiterschicht mit zumindest einer Fläche, die eine Durchmischungsstruktur aufweist, die im Idealfall zu einer annähernd ergodischen Verteilung des Lichtes in der , vorzugsweise epitaktisch hergestellten, Halbleiterschichtenfolge führt, d.h. sie weist ein möglichst ergodisch stochastisches Streuverhalten auf.

Ein Grundprinzip eines Dünnfilm-LED-Chips ist beispielsweise in I. Schnitzer et al., Appl. Phys. Lett. 63 (16), 18. Oktober 1993, 2174 - 2176 beschrieben.

Die Halbleiterfunktionsbereiche des Halbleiterchips werden in Parallelschaltung betrieben.

In einem erfindungsgemäßen Verfahren zum Ausbilden einer Kontaktstruktur zur elektrischen Kontaktierung eines optoelektronischen Halbleiterchips mit einer Mehrzahl von auf einer gemeinsamen Trägerschicht angeordneten Halbleiterfunktionsbereichen wird zunächst eine auf einer Trägerschicht angeordnete Halbleiterschichtenfolge bereitgestellt, wonach die Halbleiterschichtenfolge derart strukturiert wird, dass eine Mehrzahl von Halbleiterfunktionsbereichen entsteht. Nachfolgend werden wenigstens ein Teil der Halbleiterfunktionsbereiche bezüglich ihrer Funktion oder eines vorgegebenen Funktionsparameters getestet und Defektbereiche der Halbleiterfunktionsbereiche festgelegt und eine auf der der Trägerschicht gegenüberliegenden Seite der Halbleiterfunktionsbereiche angeordnete Kontaktstruktur zur Kontaktierung der Halbleiterfunktionsbereiche derart ausgebildet, dass die Kontaktstruktur elektrisch von den Defektbereichen isoliert ist.

Ein derartiges Verfahren erleichtert es, die defektfreien, funktionsfähigen oder einem vorgegebenen Funktionsparameter genügenden, Halbleiterfunktionsbereiche im Waferverbund zu kontaktieren. Der Funktionsparameter ist bevorzugt einer der weiter oben angeführten Funktionsparameter.

Insbesondere kann bei dem Verfahren bereits vor Inbetriebnahme, das heißt vor der elektrische Kontaktierung des Halbleiterchips mittels der Kontaktstruktur bzw. vor der Stromeinprägung in den Halbleiterchip mittels der Kontaktstruktur, diese Kontaktstruktur bereits derart ausgebildet werden, dass ein Defektbereich von der Kontaktstruktur elektrisch isoliert, insbesondere getrennt, ist. Die Kontaktstruktur wird hierzu bevorzugt nach dem Testen der Halbleiterfunktionsbereiche bezüglich ihrer Funktion oder eines vorgegebenen Funktionsparameters dementsprechend ausgebildet.

Insbesondere kann das erfindungsgemäße Verfahren zum Ausbilden einer Kontaktstruktur für einen erfindungsgemäßen optoelektronischen Halbleiterchip der oben genannten Art verwendet werden. Oben und im folgenden genannte, den Halbleiterchip betreffende, Merkmale können sich somit auch auf das erfindungsgemäße Verfahren beziehen und umgekehrt.

In einer bevorzugten Ausgestaltung erfolgt die Strukturierung der Halbleiterschichtenfolge in eine Mehrzahl von Halbleiterfunktionsbereichen von der der Trägerschicht abgewandten Seite der Halbleiterschichtenfolge her. Eine derartige Strukturierung kann beispielsweise über Maskierungs- und Ätzprozesse, etwa photolithographischen Methoden in Kombination mit nass- oder trockenchemischem Ätzen erfolgen.

In einer weiteren bevorzugten Ausgestaltung sind die Halbleiterfunktionsbereiche des Halbleiterchips voneinander beabstandet. Insbesondere können die Halbleiterfunktionsbereiche durch Zwischenräume räumlich voneinander getrennt sein. Bei der Strukturierung der Halbleiterschichtenfolge in eine Mehrzahl von Halbleiterfunktionsbereichen werden die Zwischenräume bevorzugt derart ausgebildet, dass sie bis auf die Trägerschicht oder in die Trägerschicht hinein reichen. Die Halbleiterfunktionsbereiche sind mit Vorzug frei von einer, insbesondere direkten, Verbindung über ein Element der Halbleiterschichtenfolge, wie etwa einer einzelnen Halbleiterschicht, die einer Mehrzahl von Halbleiterfunktionsbereichen gemein ist. Die Halbleiterfunktionsbereiche sind mit Vorzug durch die Zwischenräume vollständig räumlich voneinander getrennt.

Während des Testens der Halbleiterfunktionsbereiche bezüglich ihrer Funktion oder eines vorgegebenen Funktionsparameters werden bevorzugt zumindest jene Halbleiterfunktionsbereiche als Defektbereiche identifiziert, die einen letalen Defekt aufweisen und für den Betrieb des optoelektronischen Halbleiterchips nicht mit der Kontaktstruktur leitend verbunden werden sollen.

Nach dem Testen der Halbleiterfunktionsbereiche wird die Kontaktstruktur auf der der Trägerschicht gegenüberliegenden Seite der Halbleiterfunktionsbereiche angeordnet und bevorzugt mit den Halbleiterfunktionsbereichen leitend verbunden, die als bezüglich des Funktionsparameters funktionsfähig eingestuft wurden. Die Kontaktstruktur wird besonders bevorzugt so ausgebildet, dass alle Defektbereiche mit letalen, insbesondere die aktive Zone kurzschließenden, Defekten von der Kontaktstruktur elektrisch getrennt oder isoliert sind.

In einer bevorzugten Ausgestaltung der Erfindung wird ein Kontaktmaterial gemäß der Kontaktstruktur strukturiert auf der der Trägerschicht gegenüberliegenden Seite der Halbleiterfunktionsbereiche angeordnet, so dass die Defektbereiche von der Kontaktstruktur isoliert sind. Dies kann beispielsweise mittels eines Lift-Off-Prozesses unter Verwendung einer geeigneten Maskenstruktur, etwa einer Fotolackschicht, die geeignet belichtet und entwickelt wurde, erreicht werden. Die Maskenstruktur verhindert, beispielsweise durch Überdeckung oder Abschattung der relevanten Bereiche, eine leitende Verbindung des Kontaktmaterials mit dem Defektbereich.

In einer weiteren bevorzugten Ausgestaltung wird das Kontaktmaterial nach dem Anordnen auf der der Trägerschicht gegenüberliegenden Seite der Halbleiterfunktionsbereiche gemäß der Kontaktstruktur strukturiert. In einer vorteilhaften Weiterbildung wird das Kontaktmaterial gemäß einer Grobkontaktstruktur strukturiert auf der der Trägerschicht gegenüberliegenden Seite der Halbleiterfunktionsbereiche angeordnet und die Defektbereiche werden nach dem Anordnen der Kontaktstruktur, etwa über ein lasergestütztes Verfahren, gezielt von der Kontaktstruktur getrennt.

Zwischen der Trägerschicht und der Kontaktstruktur ist eine Isolationsstruktur angeordnet. Bevorzugt ist die Isolationsstruktur, beispielsweise in Form eines Isolationsmaterials, im Bereich der Zwischenräume zwischen einzelnen Halbleiterfunktionsbereichen angeordnet. Eine derartige Isolationsstruktur isoliert die Kontaktstruktur von einer auf der den Halbleiterfunktionsbereichen gegenüberliegenden Seite der Trägerschicht angeordneten Gegenkontaktstruktur elektrisch. Die Gegenkontaktstruktur ist zum Beispiel in Form einer Gegenkontaktschicht auf der Trägerschicht angeordnet.

In einer weiteren vorteilhaften Weiterbildung der Erfindung sind die Halbleiterfunktionsbereiche im Betrieb des Halbleiterchips wenigstens teilweise über die Kontaktstruktur und die Gegenkontaktstruktur parallel geschaltet beziehungsweise schaltbar.

Weitere Merkmale, bevorzugte Ausgestaltungen, Vorteile und Zweckmäßigkeiten der Erfindung ergeben sich aus der Beschreibung der folgenden Ausführungsbeispiele in Verbindung mit den Figuren.

Es zeigen
- Figur 1: eine schematische Darstellung eines Ausführungsbeispiels eines erfindungsgemäßen Verfahrensablaufs anhand von in den Figuren 1A bis 1G in verschiedenen Ansichten gezeigten Zwischenschritten und
- Figur 2: eine schematische Darstellung eines Ausführungsbeispiels eines erfindungsgemäßen optoelektronischen Halbleiterchips anhand einer schematischen Aufsicht von oben in Figur 2A und einer schematischen Schnittansicht in Figur 2B.

Gleichartige und gleich wirkende Elemente sind in den Figuren mit den gleichen Bezugszeichen versehen.

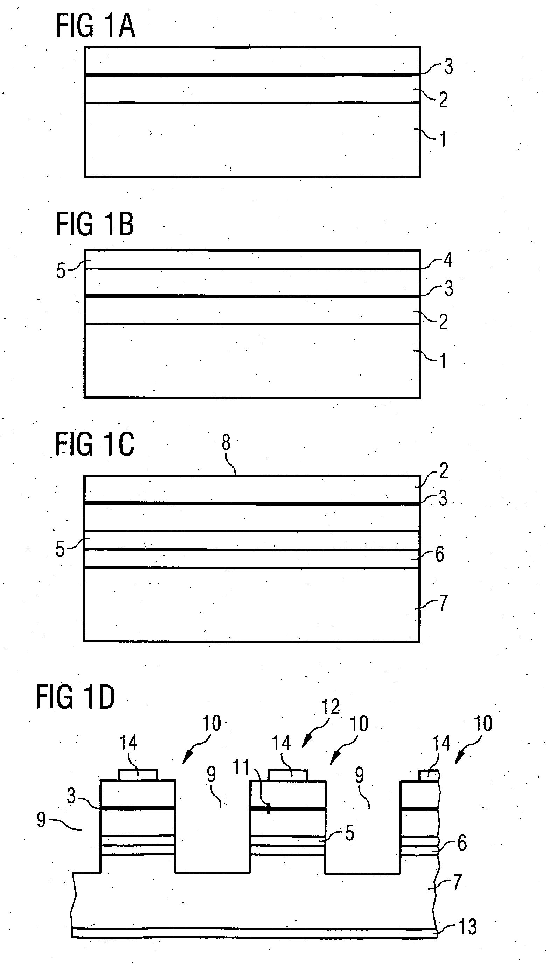

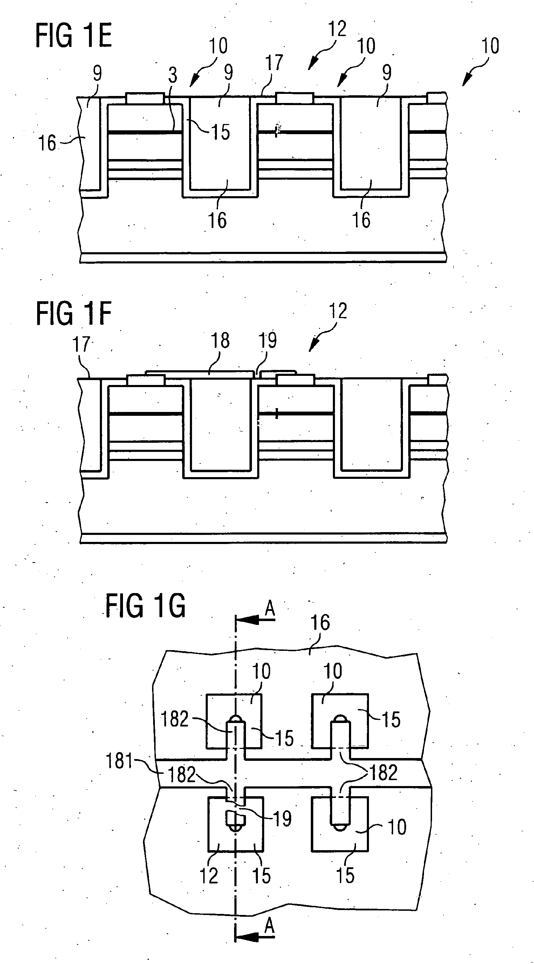

Figur 1 zeigt ein Ausführungsbeispiel eines erfindungsgemäßen Verfahrens zum Ausbilden einer Kontaktstruktur zur Kontaktierung eines optoelektronischen Halbleiterchips anhand von in den Figuren 1A bis 1G schematisch dargestellten Zwischenschritten und verschiedenen Ansichten.

Zunächst wird, wie in Figur 1A anhand einer schematischen Schnittansicht dargestellt, eine im Waferverbund auf einer ersten Trägerschicht 1 angeordnete Halbleiterschichtenfolge 2 mit einer zur Strahlungserzeugung oder zum Strahlungsempfang vorgesehenen aktiven Zone 3 bereitgestellt.

Die Halbleiterschichtenfolge, insbesondere die aktive Zone, basiert auf einem III-V-Halbleitermaterial, beispielsweise Inₓ Ga_{y} Al_{1-x-y} P, und ist in diesem Ausführungsbeispiel für LED-Chips ausgebildet.

Die erste Trägerschicht 1 ist beispielsweise das Aufwachssubstrat der Halbleiterschichtenfolge und etwa aus GaAs.

Die aktive Zone 3 umfasst gemäß einer bevorzugten Ausgestaltung der Erfindung einen pn-Übergang, eine Ein- oder Mehrfachheterostruktur, etwa eine Doppelheterostruktur. Heterostrukturen, insbesondere Doppelheterostrukturen zeichnen sich durch eine vorteilhaft hohe Quanteneffizienz aus.

Nachfolgend wird auf die der ersten Trägerschicht 1 abgewandte erste Hauptfläche 4 der Halbleiterschichtenfolge 2 eine Spiegelschicht 5, vorzugsweise vollflächig, aufgebracht. Die Spiegelschicht enthält beispielsweise ein Metall, wie Au, und kann durch Sputtern oder Aufdampfen auf die Halbleiterschichtenfolge aufgebracht werden. Dies ist in Figur 1B schematisch dargestellt. Au zeichnet sich durch eine hohe Reflektivität im roten Spektralbereich und durch gute elektrische Kontakteigenschaften zu Inₓ Ga_{y} Al_{1-x-y} P aus.

Hierauf wird der Waferverbund mit Spiegelschicht 5, Halbleiterschichtenfolge 2 und erster Trägerschicht 1 seitens der ersten Hauptfläche 4 der Halbleiterschichtenfolge, vorzugsweise über eine Verbindungsschicht 6, auf einer zweiten Trägerschicht 7 angeordnet und/oder befestigt. Die Verbindungsschicht umfasst beispielsweise eine Lotschicht oder eine in einem Waferbonding-Verfahren ausgebildete Schicht.

Die zweite Trägerschicht 7 enthält beispielsweise GaAs und kann zur Erhöhung ihrer Leitfähigkeit gemäß einer vorteilhaften Weiterbildung der Erfindung dotiert sein. Vorzugsweise ist die zweite Trägerschicht entsprechend des Leitungstyps der der Trägerschicht nächstliegenden Region der Halbleiterschichtenfolge dotiert.

Die erste Trägerschicht 1 kann nachfolgend beispielsweise über Abschleifen, Ätzen oder ein Laser-Ablations-Verfahren von der Halbleiterschichtenfolge abgelöst werden. Die daraus hervorgehende Struktur ist in Figur 1C schematisch dargestellt.

In einem nachfolgenden Verfahrensschritt wird die Halbleiterschichtenfolge 2 von der zweiten Hauptfläche 8 her derart strukturiert, dass durch Zwischenräume 9 räumlich, insbesondere vollständig, voneinander getrennte Halbleiterfunktionsbereiche 10 entstehen. Die Zwischenräume 9 erstrecken sich vorzugsweise bis in die zweite Trägerschicht 7 hinein. Die Strukturierung kann beispielsweise über photolithographische Methoden in Kombination mit Ätzprozessen erfolgen. Hierzu wird vorzugsweise seitens der zweiten Hauptfläche 8 der Halbleiterschichtenfolge 2 eine Photolackschicht aufgebracht und über strukturierte Belichtung und nachfolgende Entwicklung entsprechend der Struktur der gewünschten Zwischenräume strukturiert. Diese Maskenstruktur wird nachfolgend, etwa über nass- oder trockenchemisches Ätzen, in die Halbleiterschichtenfolge und gegebenenfalls in die zweite Trägerschicht 7 übertragen. Nachfolgend kann der noch verbliebene Photolack entfernt werden.

In Figur 1D ist der Waferverbund nach dieser Strukturierung schematisch anhand einer Schnittansicht dargestellt. Die gleichartigen Halbleiterfunktionsbereiche 10 mit den aktiven Zonen 3 und den Spiegelschichten 5 sind über die Verbindungsschichten 6 auf der zweiten Trägerschicht 7 angeordnet, die die Halbleiterfunktionsbereiche vorzugsweise mechanisch stabilisiert.

Einer der gezeigten Halbleiterfunktionsbereiche 10 weist einen letalen Defekt 11, beispielsweise vom Epitaxieprozess herrührend, auf, der die aktive Zone 3 dieses Defektbereichs 12 im Betrieb kurzschließen würde.

Die lateralen Abmessungen der Halbleiterfunktionsbereiche sind bevorzugt so gewählt, dass die Wahrscheinlichkeit, dass ein derartiger Defekt im Halbleiterfunktionsbereich auftritt, relativ gering ist. Bei herkömmlichen Halbleiterschichtenfolgen, die auf Inₓ Ga_{y} Al_{1-x-y} P basieren, treten typischerweise ungefähr 10 letale Defekte pro Quadratzentimeter der lateralen Ausdehnung der Halbleiterschichtenfolge auf, sodass die Halbleiterfunktionsbereiche zweckmäßigerweise eine entsprechend geringe lateralen Ausdehnung aufweisen. Beispielsweise können die Halbleiterfunktionsbereiche als in Aufsicht im wesentlichen rechteckige oder quadratische Halbleiterfunktionsbereiche mit einer Kantenlänge von 300 µm, vorzugsweise 200 µm oder weniger ausgeführt sein. Die Zwischenräume können in der Schnittansicht eine laterale Ausdehnung von 20 µm, vorzugsweise 10 µm, oder weniger aufweisen.

Nachfolgend werden die Halbleiterfunktionsbereiche bezüglich ihrer Funktion gemäß eines vorgegebenen Funktionsparameters und/oder letaler Defekte getestet.

Hierzu werden in einer bevorzugten Ausgestaltung der Erfindung auf der den Halbleiterfunktionsbereichen abgewandten Seite der zweiten Trägerschicht 7 eine, vorzugsweise im Wesentlichen vollflächig auf die Trägerschicht aufgebrachte, Gegenkontaktschicht 13 angeordnet und seitens der Halbleiterfunktionsbereiche Kontaktpunkte 14 vorgesehen. Über die Kontaktpunkte 14 und die Gegenkontaktschicht 13 können die Halbleiterfunktionsbereiche, beispielsweise in einem Wafer-Prober, bezüglich ihrer Funktion oder Funktionsparameter getestet werden. Die elektrische Kontaktierung der Halbleiterfunktionsbereiche erfolgt hierbei über die Kontaktpunkte 14 und die Gegenkontaktschicht 13, die über die zweite Trägerschicht 7, die Verbindungsschicht 6 und die Spiegelschicht 5 mit der aktiven Zone leitend verbunden ist. Abweichend von dem oben angeführten elektrischen Testverfahren kann die Funktion der Halbleiterfunktionsbereiche gemäß einer weiteren bevorzugten Ausgestaltung der Erfindung auch optisch getestet werden. Hierzu kann beispielsweise ein Laser einen Halbleiterfunktionsbereich zu Photolumineszenz anregen und die Intensität der re-emittierten Lumineszenzstrahlung ausgewertet werden, anhand derer mit Vorteil die Defektbereiche bestimmt werden können.

Weiterhin kann zu Testzwecken auch die Absorption eines geeigneten Laserstrahls im Halbleiterfunktionsbereich in Reflexion oder gegebenenfalls auch in Transmission bei entsprechend selektiv oder dünn ausgebildeter bzw. fehlender Spiegelschicht beobachtet werden. Hierüber können mit Vorteil zumindest die letalen Defektbereiche identifiziert werden.

Diese optischen Testverfahren können den Herstellungsaufwand aufgrund fehlender Kontaktpunkte verringern.

Während oder nach der Festlegung beziehungsweise Identifizierung der Defektbereiche 12, insbesondere jenen mit letalen Defekten, in einem gemäß Figur 1D strukturierten Waferverbund kann die Position der Defektbereiche im Waferverbund in einer Wafermap gespeichert werden, um in späteren Verfahrensschritten zur Verfügung zu stehen.

Vor oder nach dem Testvorgang wird vorzugsweise eine Isolationsstruktur in den Zwischenräumen 9 zwischen den Halbleiterfunktionsbereichen 10 angeordnet.

Diese Isolationsstruktur umfasst bevorzugt ein Füllmaterial 16 sowie besonders bevorzugt eine Passivierungsschicht 15, beispielsweise ein Siliziumnitrid, Siliziumoxid oder Siliziumoxinitrid (wie SiNₓ, SiOₓ oder SiON; x kann beispielsweise Werte, vorzugsweise ganzzahlige Werte, im Bereich 1 ≤ x ≤ 4 annehmen) enthaltend oder daraus bestehend, die den Schutz des Halbleiterfunktionsbereichs erhöht und/oder elektrisch isolierend ausgebildet ist.

Die Passivierungsschicht ist vorzugsweise strahlungsdurchlässig, umformt die Halbleiterfunktionsbereiche 10 zumindest teilweise und/oder ist direkt angrenzend an diese angeordnet. Die Passivierungsschicht kann beispielsweise im wesentlichen vollflächig, wie durch Sputtern, CVD- (Chemical Vapor Deposition) oder PECVD-Verfahren (Plasma Enhanced CVD) aufgebracht und nachfolgend derart strukturiert werden, dass die Halbleiterfunktionsbereiche elektrisch kontaktierbar sind, oder bereits entsprechend strukturiert aufgebracht werden, wobei gegebenenfalls zum strukturierten Aufbringen der Passivierungsschicht ebenfalls die obigen Verfahren eventuell in Kombination mit einer geeigneten Maske herangezogen werden können.

Das Füllmaterial 16, beispielsweise BCB (Benzo-Cyclo-Butene) enthaltend, ist bevorzugt elektrisch isolierend ausgebildet und/oder füllt die Zwischenräume 9 in vertikaler Richtung zumindest teilweise aus. Besonders bevorzugt ist das Füllmaterial zumindest während des Aufbringens plastisch formbar und/oder kann etwa durch Spincoating auf- bzw. eingebracht werden. Weiterhin härtet das Füllmaterial bevorzugt nach der Auf- bzw. Einbringung aus oder wird nach der Auf- bzw. Einbringung, vorzugsweise bei für die Halbleiterfunktionsbereiche unschädlichen Temperaturen, ausgehärtet.

In einer bevorzugten Ausgestaltung der Erfindung füllt das Füllmaterial 16 die Zwischenräume 9 derart aus, dass sich seitens der Oberfläche 17 der in Figur 1E dargestellten Struktur eine im Wesentlichen ebene Oberfläche ergibt. Zumindest ist das Füllmaterial 16 so angeordnet, dass das nachträgliche Aufbringen einer Kontaktstruktur seitens der Oberfläche 17 aufgrund des durch das Füllmaterial verflachten Reliefs der Struktur aus Figur 1E erleichtert wird. Eine Abflachung des Reliefs kann die mechanischen Belastungen eines nachfolgend aufgebrachten Kontaktmaterials und somit auch die Gefahr eines Ausfalls des Halbleiterchips beziehungsweise einzelner Halbleiterfunktionsbereiche verringern.

Abweichend von der Darstellung in den Figuren 1D und 1E können die Begrenzungen der Zwischenräume 9 auch eine vom dargestellten, im Wesentlichen rechteckigen, Querschnitt abweichende Form aufweisen. Beispielsweise kann sich die laterale Ausdehnung des Zwischenraums in Schnittansicht in Richtung der Trägerschicht verjüngen, etwa in einem trapezförmigen Querschnitt. Das Aufbringen der Passivierungsschicht 15, beispielsweise, kann dadurch erleichtert werden. Die Halbleiterfunktionsbereiche können entsprechend mesaartig - vorzugsweise mit einem zum Querschnitt der Zwischenräume komplementären, z.B. trapezförmigen, Querschnitt - auf der zweiten Trägerschicht angeordnet sein.

Nachfolgend wird seitens der Oberfläche 17 der in Figur 1E gezeigten Struktur eine Kontaktstruktur 18 derart angeordnet, dass der Defektbereich 12 von der Kontaktstruktur 18 elektrisch getrennt ist, während der defektfreie Halbleiterfunktionsbereich 10 über den Kontaktpunkt 14 elektrisch leitend mit der Kontaktstruktur verbunden ist. Die Position der Defektbereiche kann der Wafer-Map entnommen werden.

Die Kontaktstruktur 18 wird beispielsweise durch das Aufbringen eines elektrisch leitenden Kontaktmaterials, beispielsweise ein Metall, wie Au, Al, Ag, Pt, Ni, Ti, Pd oder Legierungen mit mindestens einem dieser Materialien, enthaltend, auf die Isolationsstruktur hergestellt. Dies kann beispielsweise mittels eines herkömmlichen Lift-Off-Prozesses mit einer geeignet ausgebildeten Maske erfolgen.

Zur Ausbildung eines vorteilhaften Kontakts zu p-leitenden Halbleitermaterialien beispielsweise aus dem Materialsystem Inₓ Ga_{y} Al_{1-x-y} P, eignet sich besonders AuZn, und zu n-leitenden Halbleitermaterialien aus diesem Materialsystem besonders AuGe.

Das Kontaktmaterial kann entweder bereits strukturiert seitens der Oberfläche 17 aufgebracht werden, sodass der Defektbereich 12 von der Kontaktstruktur 18 elektrisch isoliert ist, oder nach der Aufbringung entsprechend strukturiert werden.

Im ersteren Fall wird das beim Lift-Off-Prozess verwendete Maskenmaterial (z.B. ein Photolack) derart strukturiert, dass eine Kontaktierung des Defektbereichs 12 über das nachträglich aufgebrachte Kontaktmaterial verhindert wird. Die Kontaktierung des Defektbereichs kann etwa durch Abschattung oder Überdeckung der relevanten Bereiche durch das Maskenmaterial während des Aufbringens des Kontaktmaterials vermieden werden. Hierzu kann ein Photolack, beispielsweise ein Negativ-Photolack, als Maskenmaterial zunächst derart belichtet werden, dass eine Kontaktierung von im wesentlichen allen Halbleiterfunktionsbereichen, inklusive etwaiger Defektbereiche, vorgesehen ist. Nachfolgend kann der Photolack gezielt entsprechend der Anordnung der Defektbereiche, beispielsweise mittels eines Raster-Elektronen-Mikroskops (E-Beam-Belichtung), nachbelichtet werden. Bei einem Negativ-Photolack verbleibt nach dem Entwickeln in den belichteten und nachbelichteten Bereichen Photolackmaterial. Die nachbelichteten Bereiche verhindern mit Vorteil eine leitende Verbindung der Defektbereiche mit der Kontaktstruktur über die in der Folge nach dem Entwickeln gebildete Maske.

Im letzteren Fall kann das Kontaktmaterial, beispielsweise zunächst in einer Grobstruktur, die im wesentlichen mit allen Halbleiterfunktionsbereichen, defekten wie defektfreien, leitend verbunden ist, auf die Oberfläche 17 aufgebracht werden und nach der Aufbringung, beispielsweise mittels eines lasergestützten Verfahrens, strukturiert werden.

Dies ist anhand einer schematischen Schnittansicht in Figur 1F dargestellt. Mittels eines Lasers wurde die Kontaktstruktur 18 derart durchtrennt, dass ein Isolierspalt 19 den Defektbereich 12 vom Kontaktmaterial isoliert. Die Kontaktstruktur kann hierbei im Bereich über dem Defektbereich oder der Isolationsstruktur durchtrennt werden.

Anhand einer Aufsicht auf einen Teil des Waferverbunds ist dies in Figur 1G gezeigt. Hier ist zu erkennen, dass die funktionsfähigen Halbleiterfunktionsbereiche über die Kontaktpunkte 14 mit der Kontaktstruktur 18 leitend verbunden sind, die eine in der Figur 1G dargestellte Hauptleitung 181 und von der Hauptleitung abzweigende Zuleitungen 182 zu den einzelnen Halbleiterfunktionsbereichen aufweist. Figur 1F entspricht einer Schnittansicht entlang der Linie A-A aus Figur 1G.

Im Waferverbund kann für alle strukturierten Halbleiterfunktionsbereiche eine derartige Kontaktstruktur ausgebildet werden, deren konkrete Ausführung auch von der in Figur 1G gezeigten abweichen kann. Je nach gewünschter aktiver Fläche des optoelektronischen Halbleiterchips kann dann der Waferverbund derart in Teilwafer vereinzelt werden, dass einer oder mehrere optoelektronische Halbleiterchips mit vorteilhaft großer, skalierbarer, aktiver Fläche entstehen, wobei die Gefahr eines Ausfalls der Halbleiterchips im Betrieb aufgrund von Defekten in einem der Halbleiterfunktionsbereiche zumindest erheblich verringert ist.

Das Vereinzeln kann beispielsweise mittels Sägen, Lasertrennen oder Wasserstrahlschneiden erfolgen.

Die einzelnen Halbleiterfunktionsbereiches des derart hergestellten optoelektronischen Halbleiterchips können über die Gegenkontaktschicht 13 und die Kontaktstruktur 18 in Parallelschaltung betrieben werden. Die Gefahr eines Totalausfalls des Halbleiterchips durch einen kurzschließenden letalen Defekt ist durch die gezielte Ausbildung der Kontaktstruktur zumindest stark verringert.

Mit derartigen optoelektronische Halbleiterchips kann im Materialsystem Inₓ Ga_{y} Al_{1-x-y} P ein Gesamtlichtfluss von ungefähr 1000 lumen bei einer aktiven Fläche von ungefähr 4 mm x 4 mm erreicht werden. Bei einer Defektwahrscheinlichkeit für einen letalen Defekt in einer 200 µm x 200 µm großen lateralen Fläche der Halbleiterschichtenfolge von beispielsweise 1% wäre bei einer zusammenhängenden - nicht in einzelne Halbleiterfunktionsbereiche unterteilten Fläche - aktiven Fläche von 4 mm x 4 mm die Wahrscheinlichkeit eines auftretenden letalen Defekts größer als 98 %. Die Aufteilung der aktiven Fläche in Halbleiterfunktionsbereiche verringert mit Vorteil die Ausfallwahrscheinlichkeit des Halbleiterchips und erleichtert die Herstellung optoelektronischer Halbleiterchips mit vereinfacht vergrößerbarer aktiver Fläche.

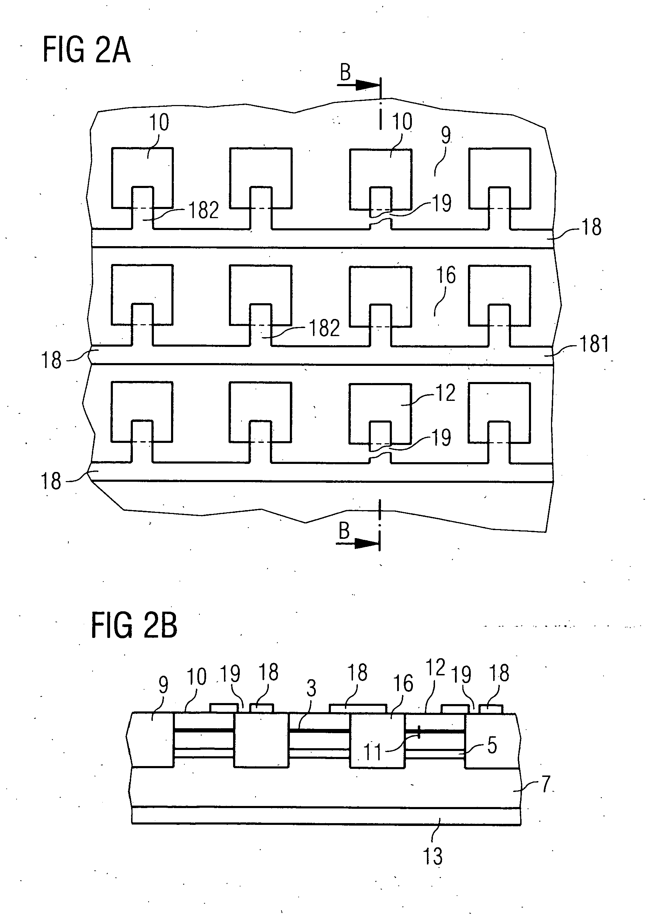

Figur 2 zeigt eine schematische Darstellung eines Teils eines Ausführungsbeispiels eines erfindungsgemäßen optoelektronischen Halbleiterchips anhand einer schematischen Aufsicht von oben in Figur 2B und einer schematischen Schnittansicht in Figur 2B entlang der Linie B-B in Figur 2A.

Beispielsweise kann der Halbleiterchip ähnlich dem in Figur 1 dargestellten Verfahren hergestellt werden.

Die Halbleiterfunktionsbereiche 10 sind in einem im Wesentlichen einem quadratischen Gitter entsprechenden Raster auf der Trägerschicht 7 angeordnet. In dem zusammenhängenden Netz aus Zwischenräumen 9 zwischen den einzelnen Halbleiterfunktionsbereichen ist ein Füllmaterial 16, beispielsweise BCB, angeordnet, das das Relief der Struktur in Figur 2B derart planarisiert, dass die Aufbringung der Kontaktstruktur 18 erleichtert ist. Zwischen den Halbleiterfunktionsbereichen und der Trägerschicht 7 ist eine Spiegelschicht 5 angeordnet. Im Gegensatz zu der in Figur 1G gezeigten Struktur ist in diesem Ausführungsbeispiel die Kontaktstruktur zeilenartig in den Zwischenräumen 9 in horizontaler Richtung in Figur 2A angeordnet. Abweichend von dieser Darstellung kann jedoch auch in den vertikalen Zwischenräumen eine Kontaktstruktur bzw. Kontaktmaterial vorgesehen sein, sodass eine im Wesentlichen kreuzgitterförmige Anordnung der Hauptleitungen 181 entsteht. Auch kann ein Halbleiterfunktionsbereich mit einer Mehrzahl von Zuleitungen 182 - beispielsweise einer von einer horizontal verlaufenden Hauptleitung ausgehenden und einer von einer vertikal verlaufenden Hauptleitung ausgehenden Zuleitung - leitend verbunden sein.

Der Defektbereich 12 ist durch einen Isolierspalt 19 von der Kontaktstruktur 18 elektrisch getrennt.

In diesem Ausführungsbeispiel ist auch ein prinzipiell funktionsfähiger, defektfreier Halbleiterfunktionsbereich von der Kontaktstruktur 18 über einen Isolierspalt 19 getrennt. Dadurch, dass gemäß einer bevorzugten Ausgestaltung der Erfindung die Anzahl der von der Kontaktstruktur getrennten Halbleiterfunktionsbereichen größer ist als die Anzahl von vorhandenen Defektbereichen, kann eine engere Verteilung der Funktionsparameter des optoelektronischen Halbleiterchips bei der Herstellung erreicht werden. Die Anzahl insgesamt von der Kontaktstruktur getrennter Halbleiterfunktionsbereiche ist bevorzugt größer als die durchschnittliche Anzahl von Defektbereichen.

In einer bevorzugten Ausgestaltung der Erfindung ist ein fester Prozentsatz, bevorzugt 5%, besonders bevorzugt 3% oder weniger der Halbleiterfunktionsbereiche des optoelektronischen Halbleiterchips von der Kontaktstruktur getrennt. Zweckmäßigerweise ist dieser Prozentsatz größer als die typische relative Häufigkeit von Defektbereichen. So könnten beispielsweise von 100 Halbleiterfunktionsbereichen 5 von der Kontaktstruktur getrennt werden.

Die weiteren funktionsfähigen Halbleiterfunktionsbereiche sind über Zuleitungen 182 mit der Kontaktstruktur 18 verbunden. Die Kontaktierung des Halbleiterchips erfolgt über die Gegenkontaktschicht 13 und die Kontaktstruktur, wobei der Defektbereich 12 im Betrieb des Halbleiterchips von der Kontaktstruktur elektrisch isoliert ist.

In einem strahlungsemittierenden oder -empfangenden Halbleiterbauelement kann ein erfindungsgemäßer optoelektronischer Halbleiterchip in einem Gehäusekörper angeordnet sein. Vorzugsweise ist der Halbleiterchip in einer Ausnehmung des Gehäusekörpers angeordnet. Die Wände der Ausnehmung können mit einem reflexionssteigerndem Material, beispielsweise ein Metall enthaltend, versehen sein.

Der Halbleiterchip kann weiterhin zumindest teilweise von einem schützenden Umhüllungsmaterial, beispielsweise ein Reaktionsharz, wie ein Acryl- oder Epoxidharz, ein Silikonharz oder ein Silikon enthaltend, umgeben oder umformt sein, das bevorzugt in der Ausnehmung angeordnet ist. Die Kontaktstruktur bzw. die Gegenkontaktschicht sind vorzugsweise mit externen Anschlüssen elektrisch leitend verbunden, über die der Halbleiterchip von der Gehäuseaußenseite kontaktierbar ist. Weiterhin ist ein derartiges Halbleiterbauelement bevorzugt oberflächenmontierbar ausgebildet (SMD: Surface Mountable Device).

Ist das Halbleiterbauelement zur Erzeugung von mischfarbigem, insbesondere weißem Licht, vorgesehen, so ist dem Halbleiterchip beispielsweise ein Lumineszenzkonversionsmaterial nachgeordnet, das die vom Halbleiterchip erzeugte Strahlung teilweise in eine vorzugsweise längerwellige Strahlung umwandelt. Aus der Mischung dieser Wellenlängen kann dann mischfarbiges Licht entstehen.

Für die derartige Erzeugung weißen Lichts basiert der Halbleiterchip bevorzugt auf Inₓ Ga_{y} Al_{1-x-y} N und erzeugt beispielsweise blaue Strahlung, die sich mit einer reemittierten gelben Strahlung eines, zum Beispiel phosphorhaltigen, Konvertermaterials in der Umhüllung zu weissem Licht mischt. Die Spiegelschicht 5 enthält beispielsweise Ag und das Aufwachssubstrat beziehungsweise die Trägerschicht SiC, GaN oder Saphir.

Mischfarbiges, insbesondere weißes, Licht kann weiterhin über geeignete Mischung von Licht mit den Grundfarben rot, grün und blau entsprechenden Wellenlängen erzeugt werden. Vorzugsweise wird mindestens eine der Grundfarben, besonders bevorzugt alle drei, über einen erfindungsgemäßen optoelektronischen Halbleiterchip erzeugt, der im Betrieb Strahlung einer entsprechenden Wellenlänge aussendet.

Es sei angemerkt, dass sich die Erfindung nicht nur auf Halbleiterchips mit einer metallischen Spiegelschicht bezieht. Vielmehr umfasst die Erfindung auch Halbleiterchips ohne Spiegelschicht oder mit einem Braggspiegel. In einem Figur 1 entsprechendem Verfahren kann in der Folge auf das Anordnen auf einer zweiten Trägerschicht verzichtet werden.

Weiterhin kann bei der Erfindung über ein entsprechend abgewandeltes Verfahren gegebenenfalls auch eine Serienschaltung der Halbleiterfunktionsbereiche des Halbleiterchips erreicht werden. Weiterhin wird eine Serienparallelschaltung der Halbleiterfunktionsbereiche des Halbleiterchips erreicht. Die Gegenkontaktschicht kann hierzu gegebenenfalls entsprechend strukturiert werden.

Zudem sei angemerkt, dass sich die Erfindung selbstverständlich nicht nur auf optoelektronische Halbleiterchips für den sichtbaren Spektralbereich bezieht. Vielmehr kann die Erfindung auch bei optoelektronischen Halbleiterchips für den nicht-sichtbaren, insbesondere den ultravioletten oder den infraroten, Spektralbereich herangezogen werden. Aufgrund der gezielten Ausbildung der Kontaktstruktur zur Isolation von Defektbereichen kann auch bei derartigen Halbleiterchips die aktive Fläche vereinfacht vergrößert werden. Im Falle strahlungsemittierender Halbleiterchips kann insbesondere die erzeugte Strahlungsleistung erhöht werden.

Die Erfindung ist nicht durch die Beschreibung anhand der Ausführungsbeispiele beschränkt.

## Patentansprüche

1. Optoelektronischer Halbleiterchip, umfassend eine Mehrzahl von Halbleiterfunktionsbereichen (10), die auf einer gemeinsamen Trägerschicht (1,7) angeordnet sind, und eine Kontaktstruktur (18) zur elektrischen Kontaktierung des optoelektronischen Halbleiterchips, wobei
- die Halbleiterfunktionsbereiche (10) eine aktive Zone (3) umfassen, die zur Strahlungserzeugung oder zum Strahlungsempfang vorgesehen ist und auf einem III-V-Halbleitermaterial basiert,
- zwischen der Trägerschicht (1,7) und der Kontaktstruktur (18) eine Isolationsstruktur (15,16) angeordnet ist, die die Kontaktstruktur von einer auf der den Halbleiterfunktionsbereichen (10) gegenüberliegenden Seite der Trägerschicht (1,7) angeordneten Gegenkontaktstruktur (13) elektrisch isoliert,
- die Halbleiterfunktionsbereiche (10) im Betrieb des Halbleiterchips in Parallelschaltung oder in Serienparallelschaltung geschaltet sind,
- zumindest einer der Halbleiterfunktionsbereiche ein Defektbereich (12) ist,
- die Kontaktstruktur mit zumindest einem der Halbleiterfunktionsbereiche elektrisch leitend verbunden ist, und
- die Kontaktstruktur von dem Defektbereich elektrisch trennbar oder elektrisch getrennt ausgebildet ist.

2. Optoelektronischer Halbleiterchip nach Anspruch 1,
**dadurch gekennzeichnet, dass**
die Trägerschicht (1) ein Aufwachssubstrat einer Halbleiterschichtenfolge (2) umfasst und die Halbleiterschichtenfolge für die Ausbildung der Halbleiterfunktionsbereiche (10) vorgesehen ist.

3. Optoelektronischer Halbleiterchip nach Anspruch 1,
**dadurch gekennzeichnet, dass**
die Trägerschicht (7) von einem Aufwachssubstrat einer Halbleiterschichtenfolge (2), die für die Ausbildung der Halbleiterfunktionsbereiche (10) vorgesehen ist, verschieden ist.

4. Optoelektronischer Halbleiterchip nach einem der vorhergehenden Ansprüche,
**dadurch gekennzeichnet, dass**
zumindest zwischen einem Teil der Halbleiterfunktionsbereiche (10) und der Trägerschicht (1,7) eine Spiegelschicht (5) angeordnet ist.

5. Optoelektronischer Halbleiterchip nach einem der vorhergehenden Ansprüche,
**dadurch gekennzeichnet, dass**
die aktive Fläche des Halbleiterchips 1 mm², 10 mm², 1 cm² oder größer ist.

6. Optoelektronischer Halbleiterchip nach Anspruch 1,
**dadurch gekennzeichnet, dass**
die Halbleiterfunktionsbereiche (10) im Betrieb des Halbleiterchips zumindest teilweise über die Kontaktstruktur (18) und die Gegenkontaktstruktur (13) parallel geschaltet sind.

7. Optoelektronischer Halbleiterchip nach einem der vorhergehenden Ansprüche,
**dadurch gekennzeichnet, dass**
die aktive Zone (3) Inₓ Ga_{y} Al_{1-x-y} P,
Inₓ Ga_{y} Al_{1-x-y} N oder Inₓ Ga_{y} Al_{1-x-y} As, jeweils mit 0≤x≤1, 0≤y≤1 und x+y≤1, enthält.

8. Verfahren zum Ausbilden einer Kontaktstruktur zur elektrischen Kontaktierung eines optoelektronischen Halbleiterchips mit einer Mehrzahl von auf einer gemeinsamen Trägerschicht (1,7) angeordneten Halbleiterfunktionsbereichen (10),
**gekennzeichnet durch** die Schritte,
a) Bereitstellen einer auf einer Trägerschicht (1,7) angeordneten Halbleiterschichtenfolge (2),
b) Strukturieren der Halbleiterschichtenfolge derart, dass eine Mehrzahl von Halbleiterfunktionsbereichen (10) entsteht, wobei die Halbleiterfunktionsbereiche (10) eine aktive Zone (3) umfassen, die zur Strahlungserzeugung oder zum Strahlungsempfang vorgesehen ist und auf einem III-V-Halbleitermaterial basiert, und zwischen der Trägerschicht (1,7) und der Kontaktstruktur eine Isolationsstruktur (15,16) angeordnet ist, die die Kontaktstruktur (18) von einer auf der den Halbleiterfunktionsbereichen (10) gegenüberliegenden Seite der Trägerschicht (1,7) angeordneten Gegenkontaktstruktur (13) elektrisch isoliert,
c) Testen wenigstens eines Teils der Halbleiterfunktionsbereiche bezüglich ihrer Funktion oder eines vorgegebenen Funktionsparameters und Festlegen von Defektbereichen (12) der Halbleiterfunktionsbereiche, sowie
d) Ausbilden einer auf der der Trägerschicht (1,7) gegenüberliegenden Seite der Halbleiterfunktionsbereiche angeordneten Kontaktstruktur (18) zur elektrischen Kontaktierung der Halbleiterfunktionsbereiche (10) derart, dass die Halbleiterfunktionsbereiche (10) im Betrieb des Halbleiterchips in Parallelschaltung oder in Serienparallelschaltung geschaltet sind und die Kontaktstruktur elektrisch von den Defektbereichen isoliert ist.

9. Verfahren nach Anspruch 8, **dadurch gekennzeichnet, dass**
ein Kontaktmaterial gemäß der Kontaktstruktur (18) strukturiert auf der der der Trägerschicht (1,7) gegenüberliegenden Seite der Halbleiterfunktionsbereiche angeordnet wird.

10. Verfahren nach Anspruch 8, **dadurch gekennzeichnet, dass**
ein Kontaktmaterial nach dem Anordnen auf der der Trägerschicht (1,7) gegenüberliegenden Seite der Halbleiterfunktionsbereiche gemäß der Kontaktstruktur (18) strukturiert wird.

11. Verfahren nach einem der Ansprüche 8 bis 10, **dadurch gekennzeichnet, dass**
die Trägerschicht (1) das Aufwachssubstrat der Halbleiterschichtenfolge (2) umfasst.

12. Verfahren nach einem der Ansprüche 8 bis 10, **dadurch gekennzeichnet, dass**
die Trägerschicht (7) vom Aufwachssubstrat der Halbleiterschichtenfolge verschieden ist.

13. Verfahren nach einem der Ansprüche 8 bis 12,
**dadurch gekennzeichnet, dass**
die aktive Zone (3), Inₓ Ga_{y} Al_{1-x-y} P, Inₓ Ga_{y} Al_{1-x-y} N oder Inₓ Ga_{y} Al_{1-x-y} As, jeweils mit 0≤x≤1, 0≤y≤1 und x+y≤1, enthält.

14. Verfahren nach einem der Ansprüche 2. 8 bis 13, **dadurch gekennzeichnet, dass**
das Verfahren im Waferverbund durchgeführt wird.

## Claims

1. An optoelectronic semiconductor chip, comprising a plurality of semiconductor function regions (10) arranged on a common carrier layer (1, 7), and a contact structure (18) for making electrical contact with the optoelectronic semiconductor chip, wherein
- semiconductor function regions (10) comprise an active zone (3) provided for radiation generation or for generation reception and based on a III-V-semiconductor material,
- an insulation structure (15, 16) is arranged between the carrier layer (1, 7) and the contact structure (18) and electrically insulates the contact structure from a counter-contact structure (13) arranged on a side of the carrier layer (1, 7) opposite to the semiconductor function regions,
- the semiconductor function regions are connected in a parallel or series-parallel connection during operation of the semiconductor chip,
- at least one of the semiconductor function regions is a defect region (12),
- the contact structure is electrically conductively connected to at least one of the semiconductor function regions, and
- the contact structure is formed such that it can be electrically isolated or is electrically isolated from the defect region.

2. The optoelectronic semiconductor chip as claimed in claim 1,
**characterized in that**
the carrier layer (1) comprises a growth substrate of a semiconductor layer sequence (2) and the semiconductor layer sequence is provided for the formation of the semiconductor function regions (10).

3. The optoelectronic semiconductor chip as claimed in claim 1,
**characterized in that**
the carrier layer (7) is different from a growth substrate of a semiconductor layer sequence (2) provided for the formation of the semiconductor function regions (10).

4. The optoelectronic semiconductor chip as claimed in one of the preceding claims,
**characterized in that**
a mirror layer (5) is arranged at least between a portion of the semiconductor function regions (10) and the carrier layer (1, 7).

5. The optoelectronic semiconductor chip as claimed in one of the preceding claims,
**characterized in that**
the active area of the semiconductor chip is 1 mm², 10 mm², 1 cm² or greater.

6. The optoelectronic semiconductor chip as claimed in claim 1,
**characterized in that**
the semiconductor function regions (10) are connected in parallel at least in part via the contact structure (18) and the counter-contact structure (13) during operation of the semiconductor chip.

7. The optoelectronic semiconductor chip as claimed in one of the preceding claims,
**characterized in that**
the active zone (3) contains InₓGa_{y}Al_{1-x-y}P, InₓGa_{y}Al_{1-x-y}N or InₓGa_{y}Al_{1-x-y}As, in each case where 0≤x≤1, 0≤y≤1 and x+y≤1.

8. A method for forming a contact structure for making electrical contact with an optoelectronic semiconductor chip having a plurality of semiconductor function regions (10) arranged on a common carrier layer (1, 7),
**characterized by** the steps of:
a) providing a semiconductor layer sequence (2) arranged on a carrier layer (1, 7),
b) patterning the semiconductor layer sequence in such a way that a plurality of semiconductor function regions (10) are produced, wherein the semiconductor function regions (10) comprise an active zone (3) provided for radiation generation or for generation reception and based on a III-V-semiconductor material, and wherein an insulation structure (15, 16) is arranged between the carrier layer (1, 7) and the contact structure (18) and electrically insulates the contact structure from a counter-contact structure (13) arranged on the side of the carrier layer (1, 7) opposite to the semiconductor function regions (10),
c) testing at least a portion of the semiconductor function regions with regard to their function or a predetermined function parameter and defining defect regions (12) of the semiconductor function regions, and also
d) forming a contact structure (18) arranged on the side of the semiconductor function regions that is opposite to the carrier layer (1, 7) for making electrical contact with the semiconductor function regions (10) in such a way that the semiconductor function regions are connected in a parallel or series-parallel connection during operation of the semiconductor chip and the contact structure is electrically insulated from the defect regions.

9. The method as claimed in claim 8,
**characterized in that**
a contact material is arranged in a manner patterned in accordance with the contact structure (18) on the side of the semiconductor function regions that is opposite to the carrier layer (1, 7).

10. The method as claimed in claim 8,
**characterized in that**
a contact material is patterned in accordance with the contact structure (18) after arrangement on the side of the semiconductor function regions that is opposite to the carrier layer (1, 7).

11. The method as claimed in one of claims 8 to 10,
**characterized in that**
the carrier layer (1) comprises the growth substrate of the semiconductor layer sequence (2).

12. The method as claimed in one of claims 8 to 10,
**characterized in that**
the carrier layer (1) is different from the growth substrate of the semiconductor layer sequence (2).

13. The method as claimed in one of claims 8 to 12,
**characterized in that**
the active zone (3) contains InₓGa_{y}Al_{1-x-y}P, InₓGa_{y}Al_{1-x-y}N or InₓGa_{y}Al_{1-x-y}As, in each case where 0≤x≤1, 0≤y≤1 and x+y≤1.

14. The method as claimed in one of claims 8 to 13,
**characterized in that**
the method is carried out in the wafer assembly.

## Revendications

1. Puce optoélectronique à semiconducteurs, comportant une pluralité de zones de fonctions à semiconducteurs (10), qui sont disposées sur une couche support commune (1, 7) et une structure de contact (18) en vue de la mise en contact électrique de la puce optoélectronique à semiconducteurs, sachant que
- les zones de fonctions à semiconducteurs (10) comportent une zone active (3) qui est prévue pour la génération de rayonnement ou pour la réception de rayonnement et basée sur un matériau de semiconducteur III-V,
- entre la couche support (1, 7) et la structure de contact (18) est disposée une structure d'isolation (15, 16), qui isole électriquement la structure de contact d'une structure de contact adverse (13) disposée sur le côté opposé aux zones de fonctions à semiconducteurs (10) de la couche support (1, 7),
- les zones de fonctions à semiconducteurs (10) sont mises en circuit en couplage en dérivation ou en couplage série-parallèle pendant le fonctionnement de la puce à semiconducteurs,
- au moins une des zones de fonctions à semiconducteurs est une zone de défaut (12),
- la structure de contact est connectée de manière conductrice électriquement avec au moins une des zones de fonctions à semiconducteurs, et
- la structure de contact est constituée de manière séparable électriquement ou séparée électriquement de la zone de défaut.

2. Puce optoélectronique à semiconducteurs selon la revendication 1,
**caractérisée en ce que**
la couche support (1) comporte un substrat d'épitaxie d'une succession de couches à semiconducteurs (2) et la succession de couches à semiconducteurs est prévue pour la constitution des zones de fonctions à semiconducteurs (10).

3. Puce optoélectronique à semiconducteurs selon la revendication 1,
**caractérisée en ce que**
la couche support (7) est différente d'un substrat d'épitaxie d'une succession de couches à semiconducteurs (2) qui est prévue pour la constitution des zones de fonctions à semiconducteurs (10).

4. Puce optoélectronique à semiconducteurs selon une quelconque des revendications précédentes,
**caractérisée en ce**
**qu'**au moins entre une partie des zones de fonctions à semiconducteurs (10) et de la couche support (1, 7) est disposée une couche de planarisation (5).

5. Puce optoélectronique à semiconducteurs selon une quelconque des revendications précédentes,
**caractérisée en ce que**
la surface active de la puce à semiconducteurs est de 1 mm², 10 mm², 1 cm² ou supérieure.

6. Puce optoélectronique à semiconducteurs selon la revendication 1,
**caractérisée en ce que**
les zones de fonctions à semiconducteurs (10) sont mises en circuit en dérivation au moins partiellement via la structure de contact (18) et via la structure de contact adverse (13) pendant le fonctionnement de la puce à semiconducteurs.

7. Puce optoélectronique à semiconducteurs selon une quelconque des revendications précédentes,
**caractérisée en ce que**
la zone active (3) contient de l'Inₓ Ga_{y} Al_{1-x-y} P, de l'Inₓ Ga_{y} Al_{1-x-y} N ou de l'Inₓ Ga_{y} Al_{1-x-y} As, respectivement avec 0≤x≤1, 0≤y≤1 et x+y≤1.

8. Procédé en vue de la constitution d'une structure de contact en vue de la mise en contact électrique d'une puce optoélectronique à semiconducteurs, avec une pluralité de zones de fonctions à semiconducteurs (10) disposées sur une couche support commune (1, 7),
**caractérisé par** les étapes de
a) mise à disposition d'une succession de couches à semiconducteurs (2) disposées sur une couche support (1, 7),
b) structuration de la succession de couches à semiconducteurs de sorte qu'une pluralité de zones de fonctions à semiconducteurs (10) est créée, sachant que les zones de fonctions à semiconducteurs (10) comportent une zone active (3) qui est prévue pour la génération de rayonnement ou pour la réception de rayonnement et basée sur un matériau de semiconducteur III-V, et qu'entre la couche support (1, 7) et la structure de contact est disposée une structure d'isolation (15, 16), qui isole électriquement la structure de contact (8) d'une structure de contact adverse (13) disposée sur le côté opposé aux zones de fonctions à semiconducteurs (10) de la couche support (1, 7),
c) test d'au moins une partie des zones de fonctions à semiconducteurs par rapport à leur fonction ou à un paramètre de fonction prescrit et détermination de zones de défauts (12) des zones de fonctions à semiconducteurs, ainsi que
d) formation d'une structure de contact (18) disposée sur le côté opposé à la couche support (1, 7) des zones de fonctions à semiconducteurs en vue de la mise en contact électrique des zones de fonctions à semiconducteurs (10), de sorte que les zones de fonctions à semiconducteurs (10) sont mises en circuit en couplage en dérivation ou en couplage série-parallèle pendant le fonctionnement de la puce à semiconducteurs et que la structure de contact est isolée électriquement des zones de défaut.

9. Procédé selon la revendication 8,
**caractérisé en ce**
**qu'**un matériau de contact est disposé de manière structurée conformément à la structure de contact (18) sur le côté opposé à la couche support (1, 7) des zones de fonctions à semiconducteurs.

10. Procédé selon la revendication 8,
**caractérisé en ce**
**qu'**un matériau de contact est structuré après la disposition sur le côté opposé à la couche support (1, 7) des zones de fonctions à semiconducteurs conformément à la structure de contact (18).

11. Procédé selon une quelconque des revendications 8 à 10,
**caractérisé en ce que**
la couche support (1) comporte le substrat d'épitaxie de la succession de couches à semiconducteurs (2).

12. Procédé selon une quelconque des revendications 8 à 10,
**caractérisé en ce que**
la couche support (7) est différente du substrat d'épitaxie de la succession de couches à semiconducteurs.

13. Procédé selon une quelconque des revendications 8 à 12,
**caractérisé en ce que**
la zone active (3) contient de l'Inₓ Ga_{y} Al_{1-x-y} P, de l'Inₓ Ga_{y} Al_{1-x-y} N ou de l'Inₓ Ga_{y} Al_{1-x-y} As, respectivement avec 0≤x≤1, 0≤y≤1 et x+y≤1.

14. Procédé selon une quelconque des revendications 8 à 13,
**caractérisé en ce que**
le procédé est exécuté en assemblage de tranche.
